**Europäisches Patentamt**

**European Patent Office**

**Office européen des brevets**

(19)

(11) Veröffentlichungsnummer : **0 172 323**
**B1**

(12) ## EUROPÄISCHE PATENTSCHRIFT

(45) Veröffentlichungstag der Patentschrift :
04.05.88

(51) Int. Cl.⁴ : **G 01 D   5/249**, **H 03 M   1/22**

(21) Anmeldenummer : **85106497.2**

(22) Anmeldetag : **25.05.85**

(54) **Messeinrichtung.**

(30) Priorität : 25.07.84 DE 3427411

(43) Veröffentlichungstag der Anmeldung :
26.02.86 Patentblatt 86/09

(45) Bekanntmachung des Hinweises auf die Patenterteilung : 04.05.88 Patentblatt 88/18

(84) Benannte Vertragsstaaten :
AT CH DE FR GB IT LI NL SE

(56) Entgegenhaltungen :
EP-A- 0 039 921
EP-A- 0 076 892
DE-A- 2 103 196
DE-A- 2 619 494
DE-B- 2 416 212
DE-C- 2 952 106

(73) Patentinhaber : Dr. Johannes Heidenhain GmbH
Nansenstrasse 17
D-8225 Traunreut (DE)

(72) Erfinder : Schmitt, Walter, Ing. (grad)
Hochgernstrasse 22
D-8225 Traunreut (DE)

**Beschreibung**

Die Erfindung betrifft eine Meßeinrichtung gemäß dem Oberbegriff des Anspruchs 1.

Bei einer derartigen Meßeinrichtung können die an den Referenzmarken erzeugten elektrischen Steuerimpulse auf verschiedene Weise verwertet werden, z. B. zum Reproduzieren der Nullposition im Zähler, zum Anfahren einer bestimmten Position zu Beginn der Messung und zur Kontrolle von Störimpulsen sowie zur Beaufschlagung einer nachgeschalteten Steuereinrichtung.

Aus der DE-PS 2 416 212 ist eine inkrementale Längen- oder Winkelmeßeinrichtung bekannt, bei der auf einem Maßstab neben der inkrementalen Teilung Referenzmarken auf einer gesonderten Spur vorgesehen sind. Die Absolutwerte dieser Referenzmarken bestimmen sich aus den unterschiedlichen Abständen zwischen den einzelnen Referenzmarken; diese Abstände zwischen den Referenzmarken werden durch Abtastung der inkrementalen Teilung ermittelt. Zur Erkennung der absoluten Position einer Referenzmarke müssen daher immer zwei Referenzmarken abgetastet werden. Dieses Verfahren ist umständlich und zeitraubend, wenn beispielsweise zwei derartige Referenzmarken weit auseinander liegen. Zudem können bei einer fehlerhaften Zählung der Inkremente zwischen zwei Referenzmarken falsche Abstände und damit falsche Absolutwerte für die Referenzmarken ermittelt werden.

In der DE-PS 2 952 106 ist eine inkrementale Längen- oder Winkelmeßeinrichtung beschrieben, bei der auf einem Maßstab neben der Teilung Referenzmarken mit jeweils unterschiedlichen Strichgruppenverteilungen vorgesehen sind. Die einzelnen Referenzmarken werden von Abtastfeldern in einer Abtasteinheit abgetastet, wobei jedes Abtastfeld einer Referenzmarke eindeutig zugeordnet ist, indem es die gleiche Strichgruppenverteilung aufweist. Diese Anordnung ist relativ aufwendig, da die Strichgruppenverteilungen der einzelnen Referenzmarken sich möglichst stark voneinander unterscheiden müssen, um eine eindeutige Identifizierung der einzelnen Referenzmarken zu ermöglichen. Die Abtasteinheit muß dabei für jede Referenzmarke ein identisches Abtastfeld aufweisen.

In der DE-OS 3 144 334 — von der der Oberbegriff des Anspruchs 1 abgeleitet ist — ist eine inkrementale Längen- oder Winkelmeßeinrichtung offenbart, bei der auf einem Maßstab neben der inkrementalen Teilung identische Referenzmarken auf einer gesonderten Spur vorgesehen sind. Zur Identifizierung der identischen Referenzmarken ist jeder Referenzmarke seriell eine Codemarke auf der gesonderten Spur zugeordnet. Diese Codemarken bestehen jeweils aus Codemarkenteilen, die beispielsweise einen bestimmten Binärzustand darstellen; der andere Binärzustand wird durch nicht vorhandene Codemarkenteile, d. h. durch Lücken dargestellt. Bei der seriellen Abtastung der gesamten Codemarke in Form der Codemarkenteile und der Lücken ergibt die Reihenfolge der beiden Binärzustände die gesamte Codeinformation zur Identifizierung der zugehörigen Referenzmarke.

Bei derartigen Meßeinrichtungen sind die Absolutwerte der Referenzmarken im allgemeinen auf den Teilungsnullpunkt der inkrementalen Teilung des Maßstabs bezogen; die Referenzmarken können daher zur Überprüfung einer einwandfreien Zählung der Teilungsinkremente zwischen den Referenzmarken bei der Abtastung der Teilung durch eine Abtasteinheit herangezogen werden, da die Abstände der Referenzmarken zueinander bekannt sind. Zwischen den einzelnen Referenzmarken wäre aber eine solche Überprüfung einer einwandfreien Zählung der Teilungsinkremente der Teilung nur mittels der seriell den einzelnen Referenzmarken zugeordneten Codemarkenteile der Codemarken möglich. Da aber zwischen den einzelnen Codemarkenteilen der Codemarken mehrere benachbarte Lücken, d. h. nicht vorhandene Codemarkenteile, entsprechend den vorliegenden Binärzuständen der Codeinformationen der Codemarken auftreten können, kann innerhalb solcher größeren Lücken keine Überprüfung einer einwandfreien Zählung der Teilungsinkremente der Teilung stattfinden.

Der Erfindung liegt die Aufgabe zugrunde, bei einer Meßeinrichtung der genannten Gattung eine möglichst lückenlose Überprüfung einer einwandfreien Zählung der Teilungsinkremente der Teilung einer Maßverkörperung im Bereich der Codemarken zu ermöglichen.

Diese Aufgabe wird erfindungsgemäß durch die kennzeichnenden Merkmale des Anspruchs 1 gelöst.

Die mit der Erfindung erzielten Vorteile bestehen insbesondere darin, daß durch die vorgeschlagene Anordnung der Codemarkenteile der Codemarken zwischen den Referenzmarken auf einfache Weise eine ständige nahezu lückenlose Überprüfung der Meßgenauigkeit der Meßeinrichtung erfolgen kann, so daß die Meßsicherheit der Meßeinrichtung und die Betriebssicherheit einer Bearbeitungsmaschine, an der die Meßeinrichtung zum Einsatz gelangt, weiter erhöht werden.

Vorteilhafte Ausbildungen der Erfindung entnimmt man den Ansprüchen 2 bis 9.

Ein Ausführungsbeispiel wird anhand der Zeichnung näher erläutert.

Es zeigen

Figur 1 schematisch eine inkrementale Längenmeßeinrichtung,

Figur 2a einen Maßstab,

Figur 2b eine Abtastplatte und

Figur 3 ein Signaldiagramm von Referenz- und Codesignalen.

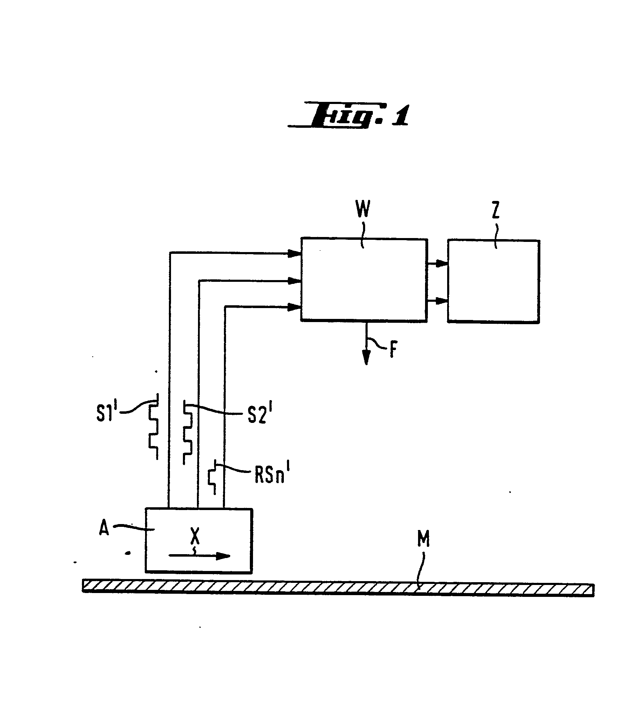

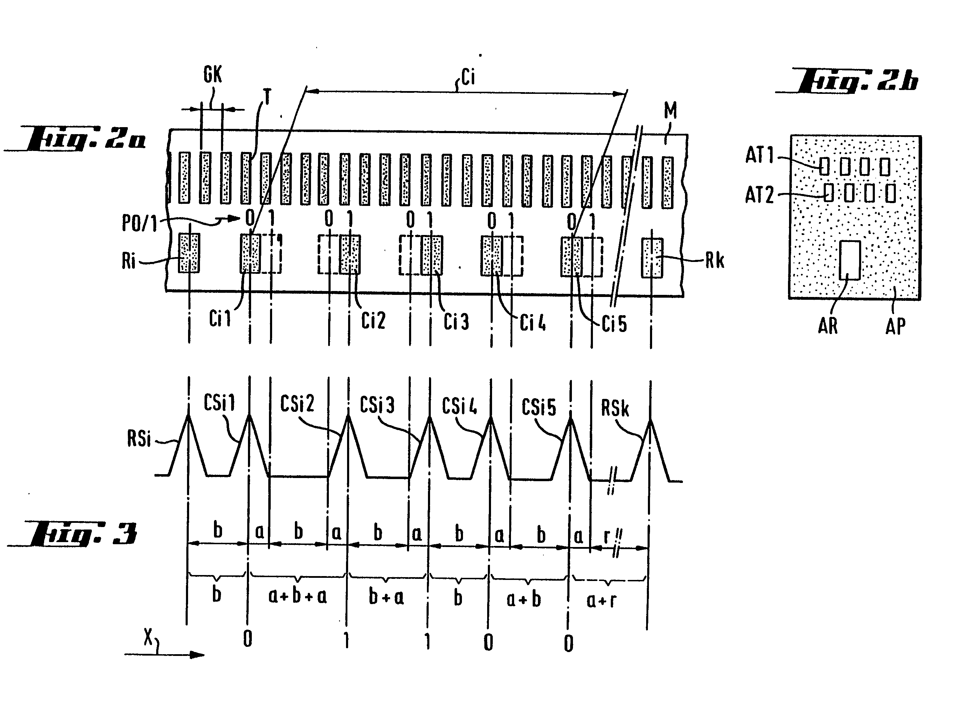

In Figur 1 ist schematisch eine lichtelektrische inkrementale Längenmeßeinrichtung gezeigt, die aus einer Maßverkörperung in Form eines Maßstabs M und aus einer Abtasteinheit A besteht, die jeweils in nicht dargestellter Weise mit einem zu messenden Objekt in Form von Maschinenteilen einer Bearbeitungsmaschine verbunden sind. Auf dem Maßstab M ist eine inkrementale Teilung T in Form eines Strichgitters (Figur 2a) aufgebracht, die im Auflicht photoelektrisch berührungsfrei von der Abtasteinheit A abgetastet wird. Entlang der Teilung T in Meßrichtung X ist auf dem Maßstab M eine Reihe von identischen Referenzmarken Rn (n = 1, 2, 3, ...) vorgesehen, die in bekannter Weise jeweils identische Strichgruppen mit einer bestimmten, aber unregelmässigen Strichverteilung aufweisen und der Teilung T fest zugeordnet sind. Gezeigt sind in Figur 2a nur zwei benachbarte Referenzmarken Ri und Rk. Für die bessere Verständlichkeit werden die Referenzmarken als einfache rechteckige Balken dargestellt.

Die durch die Abtastung der Teilung T erzeugten periodischen Abtastsignale, die in der Abtasteinheit A verstärkt und in Rechtecksignale S1', S2' umgeformt werden, beaufschlagen eine Auswerteeinrichtung W und können in einem nachgeschalteten Zähler Z als Positionsmeßwerte für die Relativlage der zu messenden Objekte angezeigt werden. Zur Richtungserkennung wird die Teilung T in bekannter Weise von Abtastfeldern AT abgetastet, die in zwei Gruppen AT1 und AT2 angeordnet sind, die um ein Viertel der Gitterkonstanten GK zueinander versetzt sind. Auf diese Weise werden zueinander phasenverschobene Abtastsignale erzeugt. An den Referenzmarken Rn werden Referenzsignale RSn erzeugt, die in der Abtasteinheit A verstärkt und in Rechtecksignale RSn' umgeformt werden und dann ebenfalls der Auswerteeinrichtung W zugeleitet werden. Die Erzeugung der Referenzsignale RSn erfolgt durch ein Referenzmarken-Abtastfeld AR, das in der Abtastplatte AP eingearbeitet ist.

Mit den aus den Referenzmarken Rn gewonnenen Referenzsignalen RSn können verschiedene Funktionen ausgelöst werden. Durch entsprechende Auswertung der Referenzsignale RSn wird beispielsweise aus einer inkrementalen Meßeinrichtung eine quasi absolute Meßeinrichtung, wenn jeder Referenzmarke Rn eine Zahl zugeordnet wird, die deren absolute Position, bezogen beispielsweise auf den Teilungsnullpunkt der Teilung T, kennzeichnet. Ferner kann eine bestimmte Referenzmarke Ro (nicht gezeigt) aus der Gesamtheit der Referenzmarken Rn dazu dienen, den Zähler Z beim Auftreten des aus der bestimmten Referenzmarke Ro gewonnenen Referenzsignals RSo auf den Wert « Null » zu setzen. Diese Funktionen sind aber nur durchführbar, wenn die ausgewählte Referenzmarke Ro eindeutig identifiziert werden kann.

Zur Identifizierung ist gemäß Figur 2a jeder einzelnen Referenzmarke Rn seriell eine Codemarke Cn zugeordnet, die aus mehreren Codemarkenteilen Cnm (n, m = 1, 2, 3, ...) besteht. Anhand der gezeigten Referenzmarke Ri und deren zugehöriger Codemarke Ci soll die Erläuterung erfolgen. Die Codemarkenteile Ci1 bis Ci5 sind von ihrer Konfiguration her identisch mit dem Muster der Referenzmarken Rn und werden durch dasselbe Referenzmarken-Abtastfeld AR abgetastet. Demgemäß sind auch sie hier vereinfacht als rechteckige Balken dargestellt.

Innerhalb der Codemarke Ci kann jedes Codemarkenteil Cim eine von zwei möglichen Positionen P0 oder P1 einnehmen. Welche der beiden möglichen Positionen P0 oder P1 das jeweilige Codemarkenteil Cim einnimmt, ist durch die Information bestimmt, die durch die Codemarke Ci ausgedrückt werden soll. Bei der Auswertung der Codeinformation wird aus der Position P0 eines Codemarkenteiles Cim der binäre Wert « 0 » abgeleitet, hat jedoch das Codemarkenteil Cim die Position P1 inne, so wird der binäre Wert « 1 » erkannt.

Im Ausführungsbeispiel besteht die gesamte Codemarke Ci aus fünf Codemarkenteilen ; Ci1 hat die Position P0 inne, Ci2 liegt auf P1, Ci3 liegt ebenfalls auf P1, Ci4 liegt wieder auf P0, ebenso wie Ci5 auf P0 liegt. Daraus läßt sich der Binärcode 0-1-1-0-0 ableiten, was der Identifizierungsschlüssel für die Codemarke Ci ist. Zur Abtastung dient wieder die Abtastplatte AP, deren Abtastfelder AT1 und AT2 die Teilung T, und deren Referenzmarken-Abtastfeld AR die Referenzmarken Rn und die Codemarken Cn abtastet. Dieser Abtastplatte AP sind Photoelemente in bekannter und daher nicht dargestellter Weise zugeordnet.

Die so gewonnenen Signale werden der Auswerteeinrichtung W zugeführt.

Bei der Abtastung des Maßstabs M gemäß Figur 2a in positiver Meßrichtung X von links nach rechts werden zuerst das Referenzsignal RSi, sodann die Codesignale CSi1 bis CSi5 und anschließend das Referenzsignal RSk erzeugt (Figur 3). Zur Erkennung der richtigen Binärkombination 0-1-1-0-0 der bei der Abtastung von links nach rechts erzeugten Codesignale CSi1 bis CSi5 als Gesamtcodeinformation der Codemarke Ci zur eindeutigen Identifizierung der zugehörigen Referenzmarke Ri müssen der Abstand a zwischen den beiden möglichen Positionen P0, P1 jedes Codemarkenteils Cim, der Abstand b zwischen benachbarten Codemarkenteilen Ci1 und Ci2, Ci2 und Ci3 usw. und ein Restabstand r zwischen dem letzten Codemarkenteil Ci5 und der folgenden Referenzmarke Rk bekannt sein, wobei der Restabstand r erkannt wird, sobald er größer als die Summe der Abstände b + 2a ist. Die Abstände a, b werden bei der Herstellung des Maßstabs M festgelegt und als Abstandsraster in einem Speicher der Auswerteeinrichtung W abgespeichert. Bei der Abtastung der Referenzmarken Ri und Rk und der Codemarkenteile Ci1 bis Ci5 werden die zwischen den Referenzsignalen RSi und den Codesignalen CSi1 bis CSi5 liegenden Abstände a, b, r mit Hilfe der Zählung der Teilungsstriche der Teilung T ermittelt und zur eindeutigen Erkennung der binären Codeinformation der einzelnen Codesignale CSi1 bis CSi5 mit dem gespeicherten Abstandsraster in der Auswerteeinrichtung W verglichen.

Bei der Abtastung des Maßstabs M in Meßrichtung X nach den Figuren 2a und 3 werden zuerst das Referenzmarkensignal RSi, sodann im Abstand b das erste Codesignal CSi1 mit der Codeinformation « 0 », im weiteren Abstand (a + b + a) das zweite Codesignal CSi2 mit der Codeinformation « 1 », im weiteren Abstand (b + a) das dritte Codesignal CSi3 mit der Codeinformation « 1 », im weiteren Abstand b das vierte Codesignal CSi4 mit der Codeinformation « 0 », im weiteren Abstand (a + b) das fünfte Codesignal CSi5 mit der Codeinformation « 0 » und anschließend im weiteren Abstand (a + r) das nächste Referenzsignal RSk ermittelt.

Wenn die Abtasteinheit A den Maßstab M in positiver Meßrichtung X von links nach rechts weiter abtastet, so folgen auf die Referenzmarke Rk die nächste Codemarke Ck mit den Codemarkenteilen Ckm und darauf die nächste Referenzmarke Rk + 1 etc. (in Figur 2a nicht mehr dargestellt).

Ganz allgemein können die Codemarken Cn Anfangs- und Endinformationen aufweisen. Mit der Anfangsinformation kann die Auswerteeinrichtung W darauf vorbereitet werden, daß im Anschluß an die Anfangsinformation eine Codeinformation ausgelesen wird. Die Endinformation dient zur Sicherstellung, daß die gesamte Codeinformation ausgelesen wurde ; dadurch kann eine eventuelle Umkehrung der Meßrichtung X mitten in der Abtastung der Codeinformationen erkannt werden.

Bei der Bewegung der Abtasteinheit A in positiver Meßrichtung X von links nach rechts erfolgt die Abtastung der Codeinformationen der Codemarkenteile Cnm nach der Abtastung der zugehörigen Referenzmarke Rn. Bei der Abtastbewegung in negativer Meßrichtung (—X) von rechts nach links wird durch den Abstand r und die richtungsabhängige Auswertung der Codeinformationen erkannt, daß nach den Codemarkenteilen Cim die Referenzmarke Ri folgen muß.

Zweckmäßig werden die Codemarkenteile Cnm und die Referenzmarken Rn als ganzzahlige Teile und/oder als ganzzahlige Vielfache der Gitterkonstanten GK der inkrementalen Teilung T auf dem Maßstab M ausgebildet, so daß die Abtastung der Codemarkenteile Cnm und der Referenzmarken Rn im Takt der Abtastung der inkrementalen Teilung T erfolgen kann. Die Abstände a, b, r betragen vorzugsweise ganzzahlige Vielfache der Teilung T.

Die Auswertung der erzeugten Codesignale CSnm sowie der Vergleich der Abstände a, b, r mit dem Abstandsraster erfolgent in der Auswerteeinrichtung VV. die eine Auswahleinrichtung aufweisen kann, mit deren Hilfe vorbestimmte Referenzmarken Rn ausgewählt und zur Wirkung gebracht werden können.

Die erfindungsgemäße serielle Anordnung der Codemarkenteile Cnm der Codemarken Cn zwischen den Referenzmarken Rn erlaubt eine ständige nahezu lükkenlose Überprüfung einer einwandfreien Zählung der Teilungsinkremente der Teilung T des Maßstabs M auch im Bereich der Codemarken Cn, da durch die Zuordnung zweier möglicher Positionen P0, P1 für jeden Codemarkenteil Cnm entsprechend der jeweiligen Codeinformation keine größeren Lücken mehr zwischen den einzelnen Codemarkenteilen Cnm der Codemarken Cn auftreten können. Jedes erzeugte Referenzsignal RSn und jedes erzeugte Codesignal CSnm kann in der Auswerteeinrichtung W zu einem Vergleich zwischen der Lage der entsprechenden Referenzmarke Rn und des entsprechenden Codemarkenteils Cnm und dem zugehörigen Zählergebnis der Teilungsinkremente der Teilung T herangezogen werden, da die Lagen der Referenzmarken Rn der Teilung T fest zugeordnet und die Lagen der einzelnen Codemarkenteile Cnm zwischen den Referenzmarken Rn durch die als Abstandsraster eingespeicherten Abstände a, b, r vorgegeben sind. Tritt bei diesem Vergleich eine Differenz zwischen den Zählergebnissen und dem Abstandsraster auf, wird von der Auswerteeinrichtung W ein Fehlersignal F ausgegeben, so daß eine fehlerhafte Messung sofort erkannt werden kann.

Als Speicher zur Abspeicherung des Abstandsrasters in der Auswerteeinrichtung W werden zweckmäßig Festwertspeicher (ROM oder PROM) verwendet. Die Anpassung der Auswerteeinrichtung W an die speziellen Abstandsraster unterschiedlicher Maßstabstypen kann durch Umprogrammieren oder Austauschen des Festwertspeichers erfolgen. In einem Festwertspeicher mit großem Speicherinhalt können die Abstandsraster für mehrere verschiedene Maßstäbe abgespeichert und das jeweilige Abstandsraster für den benutzten Maßstab beispielsweise durch den zugehörigen Abstand r des Abstandsrasters ausgewählt werden.

Zusätzliche, von den beschriebenen Abständen a, b, r abweichende Abstände können als weitere Kennungsabstände — vorzugsweise zwischen Codemarkenteilen — vorgesehen werden. Durch diese zusätzlichen Kennungsabstände kann die Auswertung synchronisiert, d. h. die Auswertung der Codemarkenteil-Signale bereits nach dem nächsten zusätzlichen Abstand begonnen werden. Durch diese Maßnahme lassen sich die Verfahrwege der Abtasteinheit A verkürzen, da nicht unbedingt der Abstand r gesucht und überfahren werden muß, sondern durch den nächstliegenden Abstand, sei es r oder einer der zusätzlichen Abstände, die Synchronisierung erfolgt.

Die Erfindung ist nicht auf das lichtelektrische Abtastprinzip beschränkt.

**Patentansprüche**

1. Meßeinrichtung zur Messung der Relativlage zweier Objekte mit mehreren entlang der Teilung (T) einer Maßverkörperung (M) in Meßrichtung (X) vorgesehenen identischen Referenzmarken (Rn), die der Teilung (T) fest zugeordnet sind und zwischen denen zur Unterscheidung jeweils eine individuelle Codemarke (Cn), die aus mehreren Codemarkenteilen (Cnm) besteht, angeordnet ist, sowie mit einer Abtasteinheit (A) zur Abtastung der Teilung (T), der Referenzmarken (Rn) und der zugehörigen Codemarken (Cn), die mit einer Auswerteeinrichtung (W) verbunden ist, in der die Auswertung der Codemarken (Cn) mittels einer elektronischen Baueinheit erfolgt, wozu die Codeinformation jeder Codemarke (Cn) in Form einer binären Zahlenkombination in der Auswerteeinrichtung (W) ansteht, dadurch gekennzeichnet, daß innerhalb einer Codemarke (Cn) jedes Codemarkenteil (Cnm) von jeweils zwei möglichen Positionen (P0 oder P1) entsprechend seiner Codeinformation eine Position (P0 oder P1) einnimmt und daß in der Auswerteeinrichtung (W) ein Abstandsraster vorgegeben ist, das den zulässigen Positionen (P0 und P1) der Codemarkenteile (Cnm) entspricht, wobei der Wert der binären Zahlenkombination von der tatsächlichen Position (P0 oder P1) der einzelnen Codemarkenteile (Cnm) abhängig ist.

2. Meßeinrichtung nach Anspruch 1, dadurch gekennzeichnet, daß das Abstandsraster durch Einspeichern des Abstandes (a) zwischen den zulässigen Positionen (P0 und P1) je eines Codemarkenteils (Cnm) und des Abstandes (b) zwischen benachbarten Codemarkenteilen (Cnm und Cnm + 1) sowie eines Maßstab-spezifischen Kennungsabstandes (r) zwischen einer Referenzmarke (Rn) und dem nächstliegenden Codemarkenteil (Cnm) vorzugsweise in einen Festwertspeicher vorgegeben wird.

3. Meßeinrichtung nach Anspruch 1, dadurch gekennzeichnet, daß zur seriellen Abtastung der Referenzmarken (Rn) und der Codemarkenteile (Cnm) der Codemarken (Cn) die in der Abtasteinheit (A) vorhandene Abtastplatte (AP) ein für die Referenzmarken (Rn) und die Codemarkenteile (Cnm) gemeinsames Abtastfeld (AR) enthält, dem ein Photoelement zugeordnet ist.

4. Meßeinrichtung nach einem der Ansprüche 1 und 2, dadurch gekennzeichnet, daß die durch das Abstandsraster vorgegebenen Abstände (a, b, r) in der Auswerteeinrichtung (W) mit der Zählung der Teilungsinkremente der Teilung (T) der Maßverkörperung (M) verglichen werden.

5. Meßeinrichtung nach Anspruch 4, dadurch gekennzeichnet, daß bei einer Differenz zwischen dem Zählergebnis der Teilungsinkremente und den durch das Abstandsraster vorgegebenen Abständen (a, b, r) von der Auswerteeinrichtung (W) ein Fehlersignal (F) erzeugbar ist.

6. Meßeinrichtung nach Anspruch 1, dadurch gekennzeichnet, daß die Codemarkenteile (Cnm) der Codemarken (Cn) außer den Codeinformationen zur Identifizierung der zugehörigen Referenzmarken (Rn) noch wenigstens Informationen zur Vollständigkeitserkennung aufweisen.

7. Meßeinrichtung nach Anspruch 1, dadurch gekennzeichnet, daß die Codemarkenteile (Cnm) der Codemarken (Cn) und die Referenzmarken (Rn) als ganzzahlige Teile oder als ganzzahlige Vielfache der Gitterkonstanten (GK) der Teilung (T) der Maßverkörperung (M) ausgebildet sind.

8. Meßeinrichtung nach Anspruch 2, dadurch gekennzeichnet, daß die Abstände (a, b, r) des Abstandsrasters ganzzahlige Teile oder ganzzahlige Vielfache der Gitterkonstanten (GK) der Teilung (T) der Maßverkörperung (M) bilden.

9. Meßeinrichtung nach Anspruch 2, dadurch gekennzeichnet, daß bei mehreren in der Auswerteeinrichtung (W) abgespeicherten Abstandsrastern für verschiedene Maßverkörperungen (M) das jeweilige Abstandsraster für die verwendete Maßverkörperung (M) anhand des Abstandes (r) auswählbar ist.

## Claims

1. Measuring device for measuring the relative position of two objects with a plurality of identical reference marks (Rn) provided along the graduation (T) of a measuring entity (M) in the measuring direction (X), which reference marks are fixedly associated with the graduation (T) and between which, for distinguishing each, is arranged an individual code mark (Cn), which consists of a plurality of code mark portions (Cnm), as well as with a sensing unit (A) for sensing the graduation (T), the reference marks (N) and the associated code marks (Cn), which is connected to an evaluation device (W) in which the evaluation of the code marks (Cn) takes place by means of an electronic unit, wherein the code information of each code mark (Cn) occurs in the evaluation device (W) in the form of a binary number combination, characterised in that within one code mark (Cn) each code mark portion (Cnm) assumes in accordance with its code information one position (P0 or P1) of two possible positions each (P0 or P1), and in that a spacing raster is assumed in the evaluation device (W) which corresponds to the permissible positions (P0 and P1) of the code mark portions (Cnm), wherein the value of the binary number combination is dependent on the actual position (P0 or P1) of the individual code mark portions (Cnm).

2. Measuring device according to claim 1, characterised in that the spacing raster is assumed by storing the distance (a) between the permissible positions (P0 and P1) of each code mark portion (Cnm) and the distance (b) between adjacent code mark portions (Cnm and Cnm + 1) as well as a scale specific characteristic distanced (r) between a reference mark (Rn) and the next adjacent code mark portion (Cnm), preferably in a read-only memory.

3. Measuring device according to claim 1, characterised in that for serial sensing of the reference mark (Rn) and the code mark portions (Cnm) of the code marks (Cn) the sensor plate (AP) provided in the sensing unit (A) comprises a common sensing field (AR) for the reference marks (Rn) and the code mark portions (Cnm), with which is associated a photo element.

4. Measuring device according to one of the claims 1 and 2, characterised in that the distances (a, b, r) assumed by the spacing raster are compared in the evaluating device (W) with the counting of the graduation increments of the graduation (T) of the measuring entity (M).

5. Measuring device according to claim 4, characterised in that an error signal (F) is generated by the evaluation device (W) on a difference between the count results of the graduation increments and the distances (a, b, r) assumed by the spacing raster.

6. Measuring device according to claim 1, characterised in that the code mark portions (Cnm) of the code marks (Cn) comprise as well as the code information for identifying the corresponding reference marks (Rn) at least information for recognition of completeness.

7. Measuring device according to claim 1, characterised in that the code mark portions (Cnm) of the code marks and the reference marks (Rn) are formed as integral portions or as integral multiples of the grid constant (GK) of the graduation (T) of the measuring entity (M).

8. Measuring device according to claim 2, characterised in that the distances (a, b, r) of the spacing raster form integral proportions or integral multiples of the grid constant (GK) of the graduation (T) of the measuring entity (M).

9. Measuring device according to claim 2, characterised in that, with a plurality of spacing rasters for different measuring entities (M) stored in the evaluation device (W), the current spacing raster for the measuring entity (M) in use is selectable in dependence upon the distance (r).

**Revendications**

1. Dispositif de mesure pour mesurer la position relative de deux objets, comprenant plusieurs repères identiques (Rn) qui, prévus le long de la division (T) d'une règle graduée (M) dans le sens (X) de la mesure, sont associés de façon fixe à la division (T) et entre lesquels est respectivement disposée, pour les distinguer, une marque code individuelle (Cn) qui se compose de plusieurs éléments de codage (Cnm), ainsi qu'une unité de balayage (A) servant à explorer la division (T), les repères (Rn) et les marques codes (Cn) correspondantes et raccordée à un dispositif d'interprétation (W) dans lequel l'interprétation des marques codes (Cn) s'effectue au moyen d'un composant électronique et pour laquelle l'information codée de chaque marque code (Cn) apparaît sous la forme d'une combinaison de chiffres binaires dans le dispositif d'interprétation (W), caractérisé par le fait qu'à l'intérieur d'une marque code (Cn), chaque élément (Cnm), sur respectivement deux positions possibles (P0, ou P1), occupe une position (P0 ou P1) conformément à son information codée, et que dans le dispositif d'interprétation (W) est préétablie une grille de distances qui correspond aux positions admissibles (P0 et P1) des éléments de codage (Cnm), la valeur de la combinaison de chiffres binaires dépendant de la position effective (P0 ou P1) des différents éléments de codage individuels (Cnm).

2. Dispositif de mesure selon la revendication 1, caractérisé par le fait que la grille de distances est préétablie par mémorisation, de préférence dans une mémoire morte, de la distance (a) entre les positions admissibles (P0 et P1) de chaque élément de codage (Cnm), de la distance (b) entre des éléments de codage voisins (Cnm et Cnm+1) ainsi que d'une distance d'identification (r), spécifique de la règle graduée, entre un repère (Rn) et l'élément de codage voisin (Cnm).

3. Dispositif de mesure selon la revendication 1, caractérisé par le fait que, pour l'exploration en série des repères (Rn) et des éléments de codage (Cnm) des marques codes (Cn), la plaque d'exploration (AP), contenue dans l'unité de balayage (A), comporte un champ d'exploration (AR) qui est commun pour les repères (Rn) et les éléments de codage (Cnm) et auquel est associée une cellule photoélectrique.

4. Dispositif de mesure selon l'une des revendications 1 et 2, caractérisé par le fait que les distances (a, b, r,), préétablies par la grille de distances, sont comparées dans le dispositif d'interprétation (W) au comptage des incréments de la division (T) de la règle graduée (M).

5. Dispositif de mesure selon la revendication 4, caractérisé par le fait que le dispositif d'interprétation (W) délivre un signal d'erreurs (F) en cas d'une différence entre le résultat du comptage des incréments de la division et les distances (a, b, r) préétablies par la grille de distances.

6. Dispositif de mesure selon la revendication 1, caractérisé par le fait que les éléments de codage (Cnm) des marques codes (Cn), en plus des informations codées pour l'identification des repères correspondants (Rn), comportent encore au moins des informations pour l'identification de l'intégralité.

7. Dispositif de mesure selon la revendication 1, caractérisé par le fait que les éléments de codage (Cnm) des marques codes (Cn) et les repères (Rn) sont réalisés sous la forme de parties entières ou de multiples entiers des constantes de grille (GK) de la division (T) de la règle graduée (M).

8. Dispositif de mesure selon la revendication 2, caractérisé par le fait que les distances (a, b, r) de la grille de distances forment des parties entières ou des multiples entiers des constantes de grille (GK) de la division (T) de la règle graduée (M).

9. Dispositif de mesure selon la revendication 2, caractérisé par le fait qu'en cas de plusieurs grilles de distances mémorisées dans le dispositif d'interprétation (W), pour différentes règles graduées (M), la grille de distances à chaque fois considérée pour la règle graduée (M) utilisée peut être choisie à l'aide de la distance (r).

# Fig. 1

**Fig. 2a**

GK

Ci

T

M

PO/1

Ri — 0 1    0 1    0 1    0 1    0 1 — Rk

Ci1    Ci2    Ci3    Ci4    Ci5

**Fig. 2b**

AT1

AT2

AR    AP

**Fig. 3**

RSi    CSi1    CSi2    CSi3    CSi4    CSi5    RSk

| b | a | b | a | b | a | b | a | b | a | r |
|---|---|---|---|---|---|---|---|---|---|---|

| b | a+b+a | b+a | b | a+b | a+r |
|---|---|---|---|---|---|

X

0    1    1    0    0

0 172 323